(19) Europäisches Patentamt / European Patent Office / Office européen des brevets

(11) **EP 3 061 121 B1**

(12) **EUROPEAN PATENT SPECIFICATION**

(45) Date of publication and mention
of the grant of the patent:
**28.08.2019 Bulletin 2019/35**

(21) Application number: **14847055.2**

(22) Date of filing: **22.09.2014**

(51) Int Cl.:
**H01L 21/027** *(2006.01)*  **B29C 59/02** *(2006.01)*
**G03F 7/027** *(2006.01)*  **G03F 7/038** *(2006.01)*
**G03F 7/00** *(2006.01)*

(86) International application number:
**PCT/JP2014/004839**

(87) International publication number:
**WO 2015/045348 (02.04.2015 Gazette 2015/13)**

(54) **METHOD FOR FORMING A PATTERNED FILM, METHOD FOR MANUFACTURING AN OPTICAL COMPONENT, METHOD FOR MANUFACTURING AN INTEGRATED CIRCUIT ELEMENT, METHOD FOR MANUFACTURING AN ELECTRONIC COMPONENT, AND METHOD FOR FORMING A RELIEF PATTERN**

VERFAHREN ZUR HERSTELLUNG EINES GEMUSTERTEN FILMS, VERFAHREN ZUR HERSTELLUNG EINER OPTISCHEN KOMPONENTE, VERFAHREN ZUR HERSTELLUNG EINES INTEGRIERTEN SCHALTUNGSELEMENTS, VERFAHREN ZUR HERSTELLUNG EINER ELEKTRONISCHEN KOMPONENTE, UND VERFAHREN ZUR HERSTELLUNG EINES RELIEFMUSTERS

PROCÉDÉ POUR FORMER UNE COUCHE À MOTIFS, PROCÉDÉ DE FABRICATION D'UN COMPOSANT OPTIQUE, PROCÉDÉ DE FABRICATION D'UN ELEMENT DE CIRCUIT INTÉGRÉ, PROCÉDÉ DE FABRICATION D'UN COMPOSANT ÉLECTRONIQUE, ET PROCÉDÉ DE FABRICATION D'UN MOTIF À RELIEF

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.09.2013 JP 2013198446**

(43) Date of publication of application:
**31.08.2016 Bulletin 2016/35**

(73) Proprietor: **Canon Kabushiki Kaisha**
**Tokyo 146-8501 (JP)**

(72) Inventors:
• **ITO, Toshiki**
**Tokyo 146-8501 (JP)**
• **ISHIDA, Shingo**
**Tokyo 146-8501 (JP)**
• **KAWASAKI, Youji**
**Tokyo 146-8501 (JP)**
• **SAKAI, Keita**
**Tokyo 146-8501 (JP)**

(74) Representative: **WESER & Kollegen**
**Patentanwälte PartmbB**
**Radeckestraße 43**
**81245 München (DE)**

(56) References cited:
**EP-A2- 1 731 963**     **WO-A2-02/10721**
**WO-A2-2004/013693**     **JP-A- 2013 033 907**
**US-A1- 2008 131 791**     **US-A1- 2011 018 168**
**US-A1- 2011 095 455**     **US-A1- 2011 236 579**
**US-A1- 2012 199 997**

**Description**

[Technical Field]

The present invention relates to a method for forming a patterned film, a method for manufacturing an optical component, a method for manufacturing a integrated circuit element (in the following also named circuit board), and a method for manufacturing an electronic component.

[Background Art]

An imprinting method is one of the lithography techniques for manufacturing devices such as semiconductor integrated circuit elements and liquid crystal display elements.
This is a method for transfer a pattern onto a work substrate, such as wafer or glass plate, by bringing a photo-curable composition on the work substrate into contact with a mold having a fine pattern, and curing the photo-curable composition in contact with the mold.

PTL 1 discloses an imprinting method for aligning a mold and a substrate. This method uses dye-by-dye alignment in which an alignment mark formed in a shot region is irradiated with light, and the displacement between the mold and the substrate is compensated according to the properties of detected light (reflected light or diffracted light). In the method disclosed in PTL 1, a Cr film is formed on the alignment mark in order to increase the accuracy of the alignment even if the reflectance at the interface between the mold and the photo-curable composition is low.

PTL 2 discloses an imprinting method using a condensable gas.

PTL 3 discloses methods for high-precision gap and orientation sensing between a transparent template and substrate for imprint lithography.

PTL 4 discloses a mold, pattern forming method on a substrate, and pattern forming apparatus for aligning mold and substrate with accuracy.

[Citation List]

[Patent Literature]

[PTL 1]
U.S. Patent No. 7136150

[PTL 2]
Japanese Patent No. 3700001

[PTL 3]
WO publication No. WO 02/10721

[PTL 4]
EP application publication No. 1 731 963

[Summary of Invention]

[Technical Problem]

In the method of PTL 1, however, the mold is repeatedly used and washed every predetermined number of imprinting operations. Accordingly, the Cr film of the alignment mark is reduced by the washing, and alignment thus becomes difficult.
PTL 2 does not describe alignment or improvement of alignment accuracy.

[Solution to Problem]

According to an aspect of the present invention, a method is provided for forming a patterned film. The method includes:

supplying a gas between photo-curable composition R on a substrate having alignment mark B and a mold having alignment mark A; bringing the photo-curable composition R into contact with the mold, thereby turning the photo-curable composition R into photo-curable composition R' in which the gas is dissolved;

detecting light coming from the alignment mark A and the alignment mark B by irradiating the mold and the substrate with light a; aligning the alignment mark A with the alignment mark B according to the detected light; curing the photo-curable composition R' into a cured film by irradiating the photo-curable composition R' with light b having a different wavelength than the light a; and separating the cured film from the mold. The gas satisfies the following Inequality (1):

[Math. 1]

$$\left| n_M - n_R \right| \leq \left| n_M - n_{R'} \right| \qquad (1)$$

In Inequality (1), $n_R$ represents the refractive index of the photo-curable composition R at the wavelength of the light a, $n_{R'}$ represents the refractive index of the photo-curable composition R' at the wavelength of the light a, and $n_M$ represents the refractive index of the mold at the wavelength of the light a.

According to another aspect of the invention, a method is provided for forming a relief pattern by photo-nanoimprinting. The method includes: disposing a photo-curable composition containing a gas between a substrate having alignment mark B and a mold provided with a relief at the surface thereof and having alignment mark A; estimating the relative positional relationship between the alignment mark A and the alignment mark B by irradiating the alignment mark A and the alignment mark B with light incapable of curing the photo-curable composition; and aligning the alignment mark A with the alignment mark B by moving the substrate relative to the mold in a direction parallel to the surface of the substrate. The gas, the photo-curable composition and the mold satisfy the following Inequality (1):

[Math. 1]

$$\left| n_M - n_R \right| \leq \left| n_M - n_{R'} \right|$$

In Inequality (1), $n_R$ represents the refractive index of the photo-curable composition not containing the gas at the wavelength of the light incapable of curing the photo-curable composition, $n_{R'}$ represents the refractive index of the photo-curable composition containing the gas at the wavelength of the light incapable of curing the photo-curable composition, and $n_M$ represents the refractive index of the mold at the wavelength of the light incapable of curing the photo-curable composition.

The present invention allows the alignment marks of a mold and a substrate to be accurately detected, and accordingly provides a method for forming a patterned film with a high throughput, reducing the time for controlling the relative displacement between the mold and the substrate. Furthermore, the present invention provides a method for manufacturing an optical component, a method for manufacturing a circuit board, and a method for manufacturing an electronic component.

Further features of the present invention will become apparent from the following description of exemplary embodiments with reference to the attached drawings. The scope of the invention is defined by the appended claims.

**Brief Description of Drawings**

[fig. 1]Fig. 1 is a flow diagram of a method for forming a patterned film according to an embodiment of the present invention.

[fig.2]Fig. 2 is a schematic view of an imprinting apparatus used in a method for forming a patterned film of an embodiment of the present invention.

[fig.3A]Fig. 3A is a schematic sectional view illustrating a process of a method for forming a patterned film according to an embodiment of the present invention.

[fig.3B]Fig. 3B is a schematic sectional view illustrating the process of the method for forming a patterned film according to the embodiment of the present invention.

[fig.3C]Fig. 3C is a schematic sectional view illustrating the process of the method for forming a patterned film according to the embodiment of the present invention.

[fig.3D]Fig. 3D is a schematic sectional view illustrating the process of the method for forming a patterned film according to the embodiment of the present invention.

[fig.3E]Fig. 3E is a schematic sectional view illustrating the process of the method for forming a patterned film according to the embodiment of the present invention.

[fig.3F]Fig. 3F is a schematic sectional view illustrating the process of the method for forming a patterned film according to the embodiment of the present invention.

[fig.4A]Fig. 4A is a sectional view illustrating a method for manufacturing an optical component, a circuit board or an electronic component according to an embodiment of the present invention.

[fig.4B]Fig. 4B is a sectional view illustrating the method for manufacturing an optical component, a circuit board or an electronic component according to the embodiment of the present invention.

**Description of Embodiments**

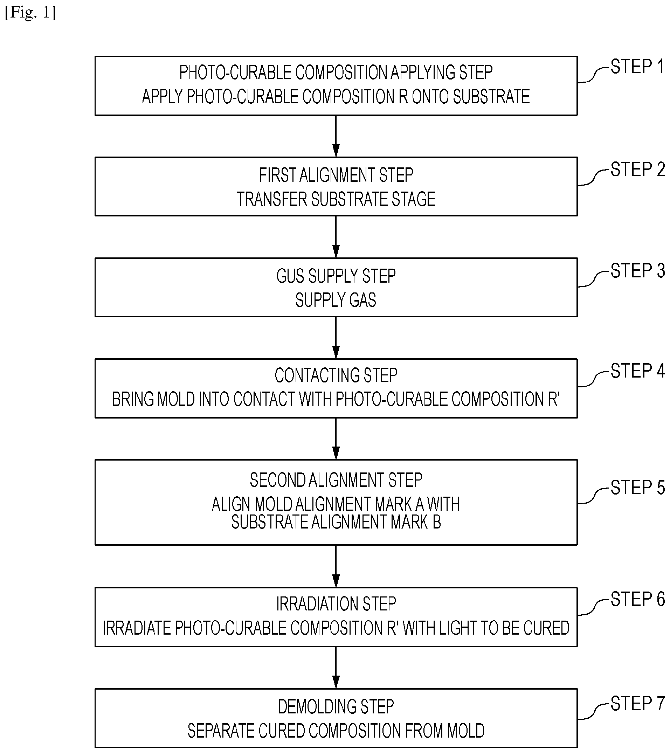

Embodiments of the invention will now be described with reference to Figs. 1 to 4B. In the figures, the same parts are designated by the same reference numerals and thus description thereof is omitted.

A method for forming a patterned film according to the present disclosure includes: supplying a gas between photo-curable composition R on a substrate having alignment mark B and a mold having alignment mark A, thereby preparing photo-curable composition R' in which the gas is dissolved; bringing the photo-curable composition R' into contact with the mold; irradiating the mold and the substrate with light a and detecting light coming from the alignment mark A and the alignment mark B; aligning the alignment mark A with the alignment mark B on the basis of the detected light; curing the photo-curable composition R' into a cured film by irradiating the photo-curable composition R' with light b having a different wavelength than the light a; and separating the cured film from the mold. In this method, the gas satisfies the following Inequality (1):

[Math.2]

$$\left| n_M - n_R \right| \le \left| n_M - n_{R'} \right| \qquad (1)$$

In Inequality (1), $n_R$ represents the refractive index of the photo-curable composition R at the wavelength of the light a, $n_R$ represents the refractive index of the photo-curable composition R' at the wavelength of the light a, and $n_M$ represents the refractive index of the mold at the wavelength of the light a.

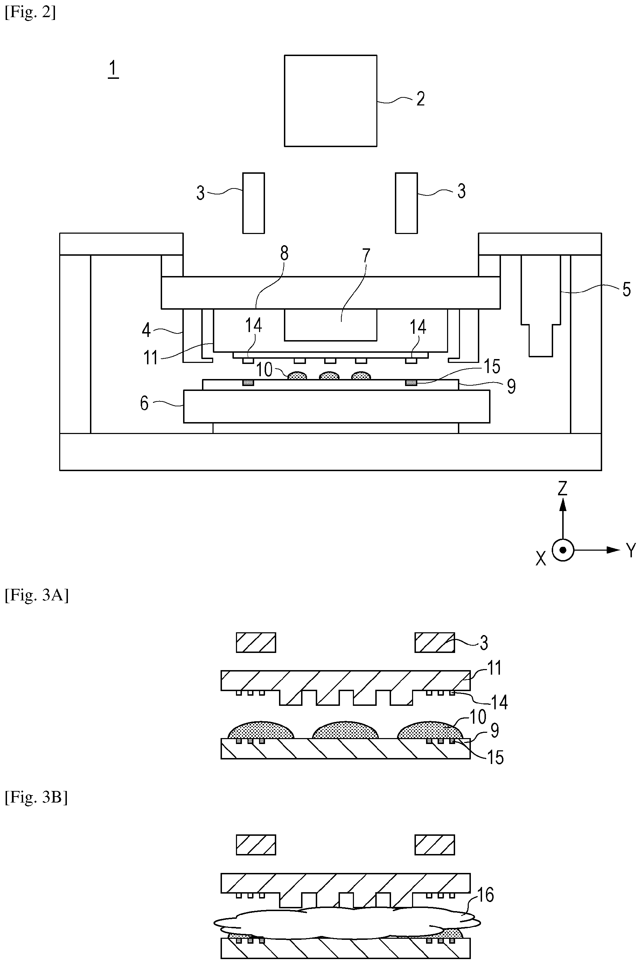

Fig. 2 is a schematic view of an apparatus used in the method of the present embodiment.

In Fig. 2, the main surface, or patterned surface, of a mold 11 is disposed parallel to the Z axis, and the other two axes perpendicular to the Z axis are the X and Y directions. The Z axis typically extends in the vertical direction.

The process steps of the method for forming a patterned film of the present embodiment will now be described.

(1. Photo-curable Composition Applying Step)

First, a coating film 10 is formed by applying photo-curable composition R onto a substrate 9, as shown in Fig. 2 (Step 1 in Fig. 1).

For applying the photo-curable composition to the surface of the substrate 9, a substrate stage 6 supporting the substrate 9 is moved to a position under an application mechanism 5 from which the photo-curable composition R is applied, and then the application mechanism 5 applies the photo-curable composition R to the surface of the substrate 9.

The application of the photo-curable composition R may be performed by, for example, an ink jet method, dip coating, air knife coating, curtain coating, a wire barcode method, gravure coating, extrusion coating, spin coating, or a slit scan method. The application mechanism 5 may be selected from the apparatuses capable of these coating methods.

The photo-curable composition mentioned herein refers to a composition that can be cured by polymerization reaction caused by being irradiated with light.

The substrate 9 may be, for example, a silicon wafer or a glass plate.

The photo-curable composition R contains a (meth)acrylate monomer that will be turned into an acrylic resin by photopolymerization, and a photopolymerization initiator.

In the method of the present embodiment, the photo-curable composition R is applied to the surface of the substrate 9. The surface of the substrate 9 may be provided with an adhesion layer or the like thereon.

The photo-curable composition R used in the present embodiment is a radically polymerizable composition containing mainly a (meth)acrylic monomer that will be turned into an acrylic resin by photopolymerization, and a photopolymerization initiator. In another embodiment, however, the photo-curable composition R may be a cationically polymerizable composition mainly containing an epoxy monomer, an oxetane monomer, a vinyl ether monomer, or the like. "Mainly containing" mentioned herein implies that the material accounts for 90% or more of the total amount of all the constituents.

(2. First Alignment Step)

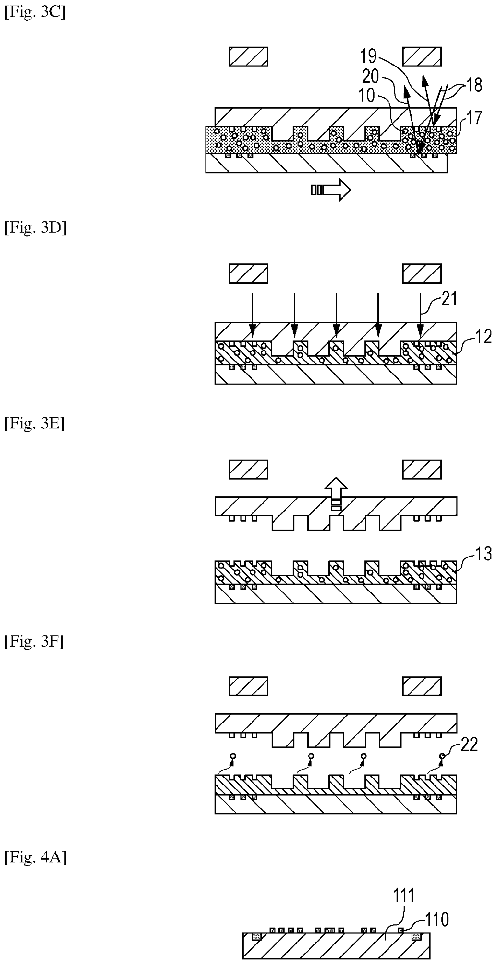

Next, for a first alignment, the substrate 9 having the coating film 10 containing the photo-curable composition R on the surface thereof is moved by the substrate state 6 so that alignment marks A, denoted by 14, of the mold 11 coincide with alignment marks B, denoted by 15, of the substrate 9 when viewed from above while the alignment marks A and the alignment marks B are observed through an alignment camera 3, as shown in Fig. 3A (Step 2 in Fig. 1).

The alignment marks A and the corresponding alignment marks B have a concavo-convex structure. Desirably, the concavo-convex structure has a periodicity.

At this time, in the first alignment, the alignment between the alignment marks A of the mold 11 and the alignment marks B of the substrate 9 is not necessarily so accurate as the order of nanometers, but is in the range of 1 micrometer to 900 micrometers.

The substrate stage 6 desirably has a suction or sticky surface so as to facilitate the transfer of the substrate 9 without the movement of the substrate on the substrate stage 6. If the substrate stage 6 has such a suction or sticky surface, the entirety of the substrate stage 6 may be made of a sucking material of a sticky material, or the substrate stage may have a sucking or sticky layer on the surface thereof.

The mold 11 is made of a material that can transmit light from a light source 2, such as quartz, silicon, a polymer, or a combination of these materials. In particular, it is advantageous that at least the portion of the mold 11 that will come into contact with the photo-curable composition R is made of quartz, and more advantageous that the entirety of the mold is made of quartz. Since quartz has a low thermal expansion coefficient, the alignment accuracy is not easily reduced even by heat of exposure light.

The mold 11 is held by a mold holding mechanism 8, and desirably has a cavity (air chamber) 7 with a smaller thickness than the other portion at the middle thereof in the surface opposite the surface that will come into contact with the photo-curable composition R. The cavity 7 helps reduce the time taken to introduce the photo-curable composition R or reduce the force required to remove the mold 11 (demolding force).

After the step of (1), the substrate 9 having the coating film 10 containing the photo-curable composition R on the surface thereof is moved to the position corresponding to the mold 11 (under the mold 11) from the position corresponding to the application mechanism 5 (under the application mechanism 5) before the step of (2).

Although, in the method of the present embodiment, the alignment marks A of the mold 11 denoted by 14 and the alignment marks B of the substrate 9 denoted by 15 are aligned with each other using the alignment camera 3, the alignment of the alignment marks A and B may be performed by any means other than using an alignment camera in another embodiment.

Also, although the alignment marks A and B have a periodic concavo-convex structure in the method of the present embodiment, the structure of the alignment marks A and B is not limited to periodic concavo-convex structures.

(3. Gas Supply Step)

Then, a gas 16 is introduced over the substrate 9 from the gas supply mechanism 4 to form an atmosphere of the gas around the coating film 10 on the substrate 9. In this step, the refractive index of the gas 16 in the form of liquid is lower than the refractive index $n_R$ of the photo-curable composition R applied in the step of (1), and the gas 16 is supplied under a lower pressure than the vapor pressure thereof or at a higher temperature than the boiling point thereof (Step 3 in Fig. 1, shown in Fig. 3B).

Desirably, the gas 16, which, in a liquid form, has a lower refractive index than the photo-curable composition R, dissolves 1 percent by volume or more in the photo-curable composition R.

Examples of such a gas include chlorofluorocarbon (CFC), fluorocarbon (FC), hydrochlorofluorocarbon (HCFC), hydrofluorocarbon (HFC), and hydrofluoroether (HFE).

More specifically, the examples of the gas include HFC-245fa (1,1,1,3,3-pentafluoropropane, $CHF_2CH_2CF_3$), HFE-245mc (pentafluoroethyl methyl ether, $CF_3CF_2OCH_3$), and HFO-1233zd (1-chloro-3,3,3-trifluoropropene, CHCl=CHCF 3).

HFC-245fa and HFE-245mc have solubilities as high as about 40 percent by volume in the photo-curable composition R mainly containing an acrylic monomer, and the liquids thereof have lower refractive indices than the acrylic monomer used as the main constituent of the photo-curable composition R. Here, for the comparison between the refractive indices of the acrylic monomer and the gas in the form of liquid, the refractive index of the acrylic monomer can be considered to be substantially the same as the refractive index of the photo-curable composition R because the acrylic monomer is the main constituent of the photo-curable composition R.

HFC-245fa and HFE-245mc are also advantageous in view of incombustibility, low toxicity and low reactivity (hence, being safe). The gas 16 may be composed of a single gas, or may contain a plurality of gases. Hence, the above-cited gases may be used singly or in combination.

The gas 16 may be a mixture of any of the cited gases and air, nitrogen, carbon dioxide, helium, argon, or the like. If a mixture of an above-cited gas is used, helium gas is suitable as the gas to be mixed. This is because helium is stable and easy to introduce for imprinting.

(4. Contacting Step)

Then, the mold 11 is brought into contact with the coating film 10 of the photo-curable composition R (Step 4 in Fig. 1).

The photo-curable composition R in the coating film 10 fills the space between the substrate 9 and the mold 11 and the recesses in the mold 11 and dissolves therein the gas 16 present there, thereby forming a coating film 17 of photo-curable composition R'.

(5. Second Alignment Step)

Subsequently, in the state where the contact between the mold 11 and the coating film 17 of the photo-curable composition R' is maintained as brought by the step of (4), alignment mark A, denoted by 14, of the mold and alignment mark B, denoted by 15, of the substrate are irradiated with light a, denoted by 18, emitted from the light source 2, and substrate stage 6 is moved to adjust the position of the substrate 9 so that the position gap between light 19 coming from alignment mark A and light 20 coming from alignment mark B is reduced while the light 19 and light 20 are being detected by the alignment camera 3 (Step 5 in Fig. 1, shown in 3C).

The light 19 and light 20 may be reflected light or diffracted light (or reflected light and diffracted light), and the position gap between the light 19 and the light 20 is a gap on the X-Y plane.

Alignment mark A and alignment mark B are the same as those used in the step of (2).

The coating film 17 of the photo-curable composition R' between the mold 11 and the substrate 9 has a refractive index (effective refractive index) $n_R$ at the wavelength of light a calculated from the following the Maxwell-Garnett formula (5): [Math.3]

$$n_{R'} = n_R \sqrt{\frac{(1 + 2V_p)n_g^2 + (2 - 2V_p)n_R^2}{(1 - V_p)n_g^2 + (2 + V_p)n_R^2}} \qquad (5)$$

$V_p$ represents the solubility of a gas in the photo-curable composition R, $n_g$ represents the refractive index of the gas in a liquid form at the wavelength of light a, and $n_R$ represents the refractive index of the photo-curable composition R at the wavelength of light a.

For the calculation using Formula (5) here, it is assumed that a gas dissolved in a liquid at a temperature more than or equal to the boiling point thereof has substantially the same refractive index as the gas in a liquid form that has been compressed at that temperature.

By dissolving a gas in the coating film of the photo-curable composition R, the refractive index of the coating film is reduced by $n_R$ - $n_{R'}$ at the wavelength of light a.

Hence, by dissolving the gas 16 in the photo-curable composition, the difference in refractive index between the mold 11 and the photo-curable composition is increased, as shown in the following inequality (1): [Math.4]

$$\left| n_M - n_R \right| \leq \left| n_M - n_{R'} \right| \qquad (1)$$

where $n_R$ represents the refractive index of the photo-curable composition R at the wavelength of light a, $n_{R'}$ represents the refractive index of the photo-curable composition R' at the wavelength of light a, and $n_M$ represents the refractive index of the mold at the wavelength of light a.

Thus, the reflectance or diffraction efficiency of light from the interface between the alignment mark A of the mold 11 and the photo-curable composition R' is increased in comparison with that of light from the interface between the alignment mark A and the photo-curable composition R, and consequently, alignment accuracy is increased.

In general, the refractive index $n_M$ of the mold 11 is higher than the refractive index $n_R$ of the photo-curable composition R, and accordingly, Inequality (2) holds true:

[Math.5]

$$0 \leq n_M - n_R < n_M - n_{R'} \qquad (2)$$

In Inequality (2), $n_R$ represents the refractive index of the photo-curable composition R at the wavelength of light a, $n_{R'}$ represents the refractive index of the photo-curable composition R' at the wavelength of light a, and $n_M$ represents the refractive index of the mold at the wavelength of light a.

Desirably, the difference between $n_R$ and $n_{R'}$ is larger, and satisfies the following Inequality (3).

[Math.6]

$$0.01 \leq n_R - n_{R'} \qquad (3)$$

In Inequality (3), $n_R$ represents the refractive index of the photo-curable composition R at the wavelength of light a, and $n_{R'}$ represents the refractive index of the photo-curable composition R' at the wavelength of light a.

Particularly when the difference between the refractive index $n_M$ of the mold 11 and the refractive index $n_R$ of the photo-curable composition R is small, for example, when the following Inequality (4) holds true, the alignment marks are easy to detect.

[Math.7]

$$0 \leq n_M - n_R \leq 0.02 \qquad (4)$$

In Inequality (4), $n_R$ represents the refractive index of the photo-curable composition R at the wavelength of light a, and $n_M$ represents the refractive index of the mold at the wavelength of light a.

In the method of the present embodiment, the substrate stage 6 is moved to adjust the position of the substrate 9 so that the position gap between the light 19 from the alignment mark A of the mold 11 and the light 20 from the alignment mark B of the substrate 9 is reduced. In another embodiment of the present invention, however, the mold may be moved to adjust the position gap between light 19 and light 20.

The wavelength of light a is preferably 500 nm or more. This is because photo-curable compositions used for imprinting are generally cured at wavelengths of 400 nm or less.

The refractive index $n_{R'}$ of the photo-curable composition R' in a case will be calculated below by way of example. In this case, light a has a wavelength of 632.8 nm, the photo-curable composition R mainly contains an acrylic monomer, HFC-245fa is used as the gas, and a quartz mold is used as the mold.

The refractive index $n_g$ of liquid HFC-245fa for light with a wavelength of 632.8 nm is 1.26, and about 40 percent by volume of HFC-245fa can dissolve in the photo-curable composition R. Hence, the solubility $V_p$ of the gas in the photo-curable composition R is 0.4, and the refractive index $n_R$ of the photo-curable composition R is 1.45 at a wavelength of 632.8 nm. The refractive index $n_M$ of the quartz mold is 1.46 at a wavelength of 632.8 nm.

When these values are substituted for $n_g$, $n_R$ and $V_p$ of Inequality (5), the refractive index $n_{R'}$ of the photo-curable composition R' in which the gas is dissolved comes to 1.38.

Thus, $n_M - n_R = 0.01$, and

$$n_M - n_{R'} = 0.08$$

The reflectance $R_{M-R}$, that is, the effective reflectance at the interface between the alignment mark A of the mold and the photo-curable composition R, is obtained using the refractive index $n_M$ of the mold and the refractive index $n_R$ of the photo-curable composition R, as shown in the following Equation (6):
[Math. 8]

$$R_{M-R} = \frac{(n_M - n_R)^2}{(n_M + n_R)^2} \qquad (6)$$

As described above, the refractive index $n_M$ of the mold is 1.46 for light with a wavelength of 632.8 nm, and the refractive index $n_R$ of the photo-curable composition R is 1.45 for light with a wavelength of 632.8 nm; hence the reflectance $R_{M-R}$ is 0.118 x $10^{-4}$.
The reflectance $R_{M-R'}$ at the interface between the alignment mark A of the mold and the photo-curable composition R' in which the gas is dissolved is obtained using the refractive index $n_M$ of the mold and the refractive index $n_{R'}$ of the photo-curable composition R', as shown in the following Equation (7):
[Math.9]

$$R_{M-R'} = \frac{(n_M - n_{R'})^2}{(n_M + n_{R'})^2} \qquad (7)$$

As described above, the refractive index $n_M$ of the mold is 1.46 for light with a wavelength of 632.8 nm, and the refractive index $n_{R'}$ of the photo-curable composition R' is 1.38 for light with a wavelength of 632.8 nm; hence the reflectance $R_{M-R'}$ is 7.93 x $10^{-4}$.
Thus, by dissolving the gas in the photo-curable composition R, the reflectance at the interface between the alignment mark A of the mold and the photo-curable composition R' is increased to about 67 times the reflectance at the interface between the alignment mark A and the photo-curable composition R.

(6. Irradiation Step)

Subsequently, the photo-curable composition R' is irradiated with light b, denoted by 21, from the light source 2 to cure the photo-curable composition R' into a cured composition 12 (Step 6 in Fig. 1, shown in Fig. 3D).
For this operation, light b has a different wavelength from light a used in the step of (5). This is because light a needs to have a wavelength at which the photo-curable composition R' is difficult to cure, whereas light b needs to have a wavelength at which the photo-curable composition R' is cured.
For example, light b may be, but is not limited to, ultraviolet light.

(7. Demolding Step)

Subsequently, the cured composition 12 is separated from the mold 11 to yield a patterned film 13.
In the demolding step, the cured composition 12 is separated from the mold 11 to yield a pattern of the cured composition or cured film 12, as shown in Fig. 3F. This resulting pattern is the counter pattern to the fine pattern of the mold 11, formed on the mold 11 in the step of (6) (irradiation step).
How to separate the cured composition or cured film 12 from the mold 11, including the conditions for demolding, is not particularly limited as long as a part of the cured film 12 is not physically damaged. For example, the mold 11 may be moved so as to go away from the substrate 9 fixed, or the substrate 9 may be moved so as to go away from the mold 11 fixed. Alternatively, the mold and the substrate may be drawn in the opposite directions so as to separate from each other.
In this step, although a gas 22 is evaporated from the patterned film 13 as shown in Fig. 3F, part of the gas can remain in the film.
In the above-described process including the steps of (1) to (7), a cured film having a desired pattern formed based on the relief pattern of the mold 11 in a desired position can be formed. The resulting cured film may be used as, for example, an optical member such as a Fresnel lens or a diffraction grating, or a member in the optical member. In this instance, the optical member includes at least the substrate 11 and the patterned film 13 on the substrate 11.
In the method of the present embodiment, the series of the steps (1) to (7), or a repeating unit (shot), may be repeated several times for the same substrate. By repeating the repeating unit (shot) including the steps of (1) to (7) several times, a cured film can be formed which has a desired pattern formed based on the relief pattern of the mold 11 in a plurality of desired positions. From the viewpoint of reducing in-plane variation among shot regions to increase the accuracy (resolution) in transferring the pattern, the thickness of the photo-curable composition R remaining on the substrate 9 described in the step of (8) is desirably as small as possible.

In a modification of the present embodiment, the method for forming a patterned film may include:

the photo-curable composition applying step of supplying and applying a photo-curable composition onto a substrate having alignment mark B from a photo-curable composition application mechanism; the stage moving step of moving a substrate stage on which the substrate is disposed from the photo-curable composition application mechanism so that the substrate is placed under a mold having alignment mark A with an accuracy from 1 micrometer to 900 micrometers; the high-solubility low-refractive-index gas supply step of supplying a gas containing a high-solubility low-refractive-index gas between the substrate and the mold; the contacting step of bringing the photo-curable composition into contact with the mold;

the alignment step of operating the substrate stage so that the alignment mark A is aligned with the alignment mark B at position Y; the irradiation step of irradiating the photo-curable composition with light; and the demolding step of separating the photo-curable composition from the mold after the irradiation step. The high-solubility low-refractive-index gas has a solubility of 10 percent by volume or more in the photo-curable composition, and the gas in a liquid form has a lower refractive index than the photo-curable composition. The mold may be a nanoimprinting mold having a nanometer-relief pattern at the surface thereof.

The method of an embodiment of the invention can be used as a method for forming a relief pattern by photo-nanoimprinting.

In this instance, the method for forming a relief pattern includes: the step of disposing a photo-curable composition containing a gas between a substrate having alignment mark B and a mold provided with a relief at the surface thereof and having alignment mark A; the step of estimating the relative positional relationship between the alignment mark A of the mold and the alignment mark B of the substrate by irradiating the alignment marks A and B with light incapable of curing the photo-curable composition; and the step of aligning the alignment mark A with the alignment mark B by moving the substrate relative to the mold in a direction parallel to the surface of the substrate. The gas, the photo-curable composition and the mold satisfy the following Inequality (1):

[Math. 10]

$$\left| n_M - n_R \right| \leq \left| n_M - n_{R'} \right| \qquad (1)$$

In Inequality (1), $n_R$ represents the refractive index of the photo-curable composition not containing the gas at the wavelength of the light incapable of curing the photo-curable composition, $n_{R'}$ represents the refractive index of the photo-curable composition containing the gas at the wavelength of the light incapable of curing the photo-curable composition, and $n_M$ represents the refractive index of the mold at the wavelength of the light incapable of curing the photo-curable composition.

(8. Residual film Removing Step)

Part of the cured film, having a specific pattern, obtained through the step of (7) or the demolding step can remain in a region other than the region in which the pattern should be formed (hereinafter such a portion of the film may be referred to as a residual film). In this instance, the portion (residual film) of the cured film having the resulting pattern in the region 111 where the film is not required is removed to yield a cured pattern 110 having a desired relief pattern (formed based on the relief pattern of the mold 11).

In this step, the residual film can be removed by, for example, etching the recessed portions (residual films) of the patterned film 13 to expose the surface of the substrate in the recesses of the patterned film 13, as shown in Fig. 4A.

For removing the film 13 in the recessed portions by etching, any technique may be applied without particular limitation, and a known technique, such as dry etching, may be performed. For the dry etching, a known dry etching apparatus can be used. The source gas used for this dry etching can be selected, according to the elemental composition of the cured film to be etched. Examples of the source gas include halogen-containing gases, such as $CF_4$, $C_2F_6$, $C_3F_8$, $CCl_2F_2$, $CCl_4$, $CBrF_3$, $BCl_3$, $PCl_3$, $SF_6$, and $Cl_2$; oxygen-containing gases, such as $O_2$, $CO$, and $CO_2$; inert gases, such as He, $N_2$, and Ar; and other gases such as $H_2$ and $NH_3$. A mixed gas of these gases may be used.

In the above-described process including the steps of (1) to (8), a cured pattern having a desired relief pattern (formed based on the relief pattern of the mold 11) in a desired position can be formed, and an article having the cured pattern can be produced.

If the substrate is worked using the cured pattern, a substrate working step (Step of (9)) is performed as described below.

Alternatively, the resulting cured pattern 110 may be used as an optical member such as a diffraction grating or a polarizer, or a member in the optical member to produce an optical component. In this instance, the optical component includes at least the substrate 102 and the cured pattern 110 on the substrate 102.

(9. Substrate Working Step)

The cured pattern 110 having a relief pattern obtained by the method for forming a patterned film of an embodiment of the present invention may be used as an interlayer insulating film of a semiconductor device, such as LSI, system LSI, DRAM, SDRAM, RDRAM, or D-RDRAM, or as a resist film used in a semiconductor manufacturing process.

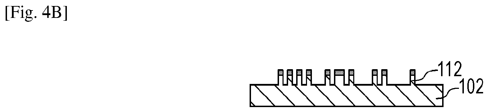

If the cured pattern 110 is used as a resist film for producing an electronic component, the portions (regions denoted by 111 in Fig. 4A) of the substrate exposed by the step of (8), etching step, are subjected to etching or ion implantation. In this instance, the cured pattern 110 functions as an etching mask. Thus, a circuit structure 112 (Fig. 4B) is formed on the substrate 102 according to the profile of the cured pattern 110). Thus, a circuit board used in a semiconductor device or the like is produced. By connecting the resulting circuit board to a control mechanism for the circuit board, an electronic component is produced for a display, a camera, a medical instrument, or any other apparatus.

Similarly, the cured pattern 110 may be used as a resist film for etching or ion implantation in a process for manufacturing an optical component.

In a process for manufacturing a circuit-including substrate or an electronic component, the cured pattern 110 may finally be removed from the substrate, but may be left as a member of a device.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

This application claims the benefit of Japanese Patent Application No. 2013-198446, filed September 25, 2013.

**Reference Signs List**

1: apparatus adapted to form a patterned film
2: light source
3: alignment camera
4: gas supply mechanism
5: application mechanism
6: substrate stage
7: cavity
8: mold holding mechanism
9: substrate
10: coating film
11: mold
12: cured composition
13: patterned film
14: alignment mark A of a mold
15: alignment mark B of a substrate
16: gas
17: coating film
18: light a
19: light
20: light
21: light b
22: evaporated gas
102: substrate
110: cured pattern
111: region of a cured patterned film to be removed
112: circuit structure formed based on the profile of a cured pattern

**Claims**

1. A method for forming a patterned film, the method comprising:

   supplying a gas (16) between photo-curable composition R (10) on a substrate (9) having alignment mark B (15) and a mold (11) having alignment mark A (14);
   bringing the photo-curable composition R into contact with the mold, thereby turning the photo-curable composition R into photo-curable composition R' in which the gas is dissolved;
   detecting light from the alignment mark A and the alignment mark B by irradiating the mold and the substrate with light a;
   aligning the alignment mark A with the alignment mark B according to the detected light;
   curing the photo-curable composition R' into a cured film by irradiating the photo-curable composition R' with light b having a different wavelength than the light a; and
   separating the cured film from the mold,
   wherein the gas satisfies the following Inequality (1):

   $$\left| n_M - n_R \right| \leq \left| n_M - n_{R'} \right| \qquad (1)$$

   wherein $n_R$ represents the refractive index of the photo-curable composition R at the wavelength of the light a, $n_{R'}$ represents the refractive index of the photo-curable composition R' at the wavelength of the light a, and $n_M$ represents the refractive index of the mold at the wavelength of the light a.

2. The method according to Claim 1, wherein the gas satisfies the following Inequality (2):

   $$0 \leq n_M - n_R < n_M - n_{R'} \qquad (2)$$

   wherein $n_R$ represents the refractive index of the photo-curable composition R at the wavelength of the light a, $n_{R'}$ represents the refractive index of the photo-curable composition R' at the wavelength of the light a, and $n_M$ represents the refractive index of the mold at the wavelength of the light a.

3. The method according to Claim 1 or 2, wherein the gas satisfies the following Inequality (3):

   $$0.01 \leq n_R - n_{R'} \qquad (3)$$

   wherein $n_R$ represents the refractive index of the photo-curable composition R at the wavelength of light a, and $n_{R'}$ represents the refractive index of the photo-curable composition R' at the wavelength of light a.

4. The method according to any one of Claims 1 to 3, wherein the photo-curable composition R and the mold satisfy the following Inequality (4):

   $$0 \leq n_M - n_R \leq 0.02 \qquad (4)$$

   wherein $n_R$ represents the refractive index of the photo-curable composition R at the wavelength of light a, and $n_M$ represents the refractive index of the mold at the wavelength of light a.

5. The method according to any one of Claims 1 to 4, wherein the photo-curable composition R mainly contains a (meth)acrylate.

6. The method according to any one of Claims 1 to 5, wherein the gas contains 1,1,1,3,3-pentafluoropropane.

7.   The method according to Claim 6, wherein the gas is a mixture of 1,1,1,3,3-pentafluoropropane and helium.

8.   The method according to any one of Claims 1 to 5, wherein the gas is 1,1,1,3,3-pentafluoropropane.

9.   The method according to any one of Claims 1 to 8, wherein the surface of the mold coming into contact with the photo-curable composition R is made of quartz.

10.  The method according to any one of Claims 1 to 8, wherein the entirety of the mold is made of quartz.

11.  The method according to any one of Claims 1 to 10, wherein the alignment mark A and the alignment mark B have a periodic concavo-convex structure.

12.  The method according to any one of Claims 1 to 11, wherein light from the alignment mark A and the alignment mark B is reflected light or diffracted light.

13.  The method according to claim 1, further comprising:

   a step of supplying and applying the photo-curable composition onto the substrate having the alignment mark B from a photo-curable composition application mechanism (5);
   a step of moving a substrate stage (6) on which the substrate (9) is disposed from the photo-curable composition application mechanism so that the substrate is placed under the mold (11) having the alignment mark A with the alignment mark A aligned with the alignment mark B with an accuracy of 1 micrometer to 900 micrometers; and
   a step of separating the photo-curable composition from the mold after the irradiation step,
   wherein the gas is a high-solubility low-refractive-index gas with a solubility of 10 percent by volume or more in the photo-curable composition, and the gas in a liquid form has a lower refractive index than the photo-curable composition.

14.  A method for manufacturing an optical component, the method comprising forming a patterned film by the method as set forth in any one of Claims 1 to 12.

15.  A method for manufacturing an optical component, the method comprising:

   forming a patterned film by the method as set forth in any one of Claims 1 to 12; and
   working the substrate by etching or ion implantation using the patterned film as a mask.

16.  A method for manufacturing a integrated circuit element, the method comprising:

   forming a patterned film by the method as set forth in any one of Claims 1 to 12;
   working the substrate by etching or ion implantation using the patterned film as a mask; and
   preparing an electronic component.

17.  A method for manufacturing an electronic component, the method comprising:

   manufacturing a integrated circuit element by the method as set forth in Claim 16; and
   connecting the integrated circuit element to a control mechanism configured to control the integrated circuit element.

18.  The method according to any one of Claim 1 to 17, wherein the mold is a nanoimprinting mold having a nanometer-relief pattern at the surface thereof.

19.  The method according to Claim 16, wherein the integrated circuit element is a semiconductor device.

20.  Use of a integrated circuit element manufactured according to Claim 16 in a semiconductor device.

21.  A method for forming a relief pattern by photo-nanoimprinting, the method comprising:

   disposing a photo-curable composition containing a gas between a substrate having alignment mark B and a mold provided with a relief at the surface thereof and having alignment mark A;

estimating the relative positional relationship between the alignment mark A and the alignment mark B by irradiating the alignment mark A and the alignment mark B with light incapable of curing the photo-curable composition; and

aligning the alignment mark A with the alignment mark B by moving the substrate relative to the mold in a direction parallel to the surface of the substrate,

wherein the gas, the photo-curable composition and the mold satisfy the following Inequality (1):

$$\left| n_M - n_R \right| \leq \left| n_M - n_{R'} \right| \qquad (1)$$

wherein $n_R$ represents the refractive index of the photo-curable composition not containing the gas at the wavelength of the light incapable of curing the photo-curable composition, $n_{R'}$ represents the refractive index of the photo-curable composition containing the gas at the wavelength of the light incapable of curing the photo-curable composition, and $n_M$ represents the refractive index of the mold at the wavelength of the light incapable of curing the photo-curable composition.

**Patentansprüche**

1.  Verfahren zum Erzeugen eines strukturierten Films, wobei das Verfahren umfasst:

    Zuführen eines Gases (16) zwischen einer lichthärtbaren Zusammensetzung R (10) auf einem Substrat (9) mit einer Ausrichtungsmarkierung B (15) und einer Form (11) mit einer Ausrichtungsmarkierung A (14);
    In-Kontakt-Bringen der lichthärtbaren Zusammensetzung R mit der Form, um dadurch die lichthärtbare Zusammensetzung R in eine lichthärtbare Zusammensetzung R' zu wandeln, in welcher das Gas gelöst ist;
    Detektieren von Licht von der Ausrichtungsmarkierung A und der Ausrichtungsmarkierung B durch Bestrahlen der Form und des Substrats mit Licht a;
    Ausrichten der Ausrichtungsmarkierung A auf die Ausrichtungsmarkierung B gemäß dem detektierten Licht;
    Härten der lichthärtbaren Zusammensetzung R' zu einem gehärteten Film durch Bestrahlen der lichthärtbaren Zusammensetzung R' mit Licht b, das eine von Licht a verschiedene Wellenlänge aufweist; und
    Trennen des gehärteten Films von der Form,
    wobei das Gas die folgende Ungleichung (1) erfüllt:

$$\left| n_M - n_R \right| \leq \left| n_M - n_{R'} \right| \qquad (1)$$

    wobei $n_R$ den Brechungsindex der lichthärtbaren Zusammensetzung R bei der Wellenlänge des Lichts a darstellt, $n_{R'}$ den Brechungsindex der lichthärtbaren Zusammensetzung R' bei der Wellenlänge des Lichts a darstellt, und $n_M$ den Brechungsindex der Form bei der Wellenlänge des Lichts a darstellt.

2.  Verfahren nach Anspruch 1, wobei das Gas die folgende Ungleichung (2) erfüllt:

$$0 \leq n_M - n_R < n_M - n_{R'} \qquad (2)$$

    wobei $n_R$ den Brechungsindex der lichthärtbaren Zusammensetzung R bei der Wellenlänge des Lichts a darstellt, $n_{R'}$ den Brechungsindex der lichthärtbaren Zusammensetzung R' bei der Wellenlänge des Lichts a darstellt, und $n_M$ den Brechungsindex der Form bei der Wellenlänge des Lichts a darstellt.

3.  Verfahren nach Anspruch 1 oder 2, wobei das Gas die folgende Ungleichung (3) erfüllt:

$$0,01 \leq n_R - n_{R'} \qquad (3)$$

wobei $n_R$ den Brechungsindex der lichthärtbaren Zusammensetzung R bei der Wellenlänge von Licht a darstellt und $n_{R'}$ den Brechungsindex der lichthärtbaren Zusammensetzung R' bei der Wellenlänge von Licht a darstellt.

4. Verfahren nach einem der Ansprüche 1 bis 3, wobei die lichthärtbare Zusammensetzung R und die Form folgende Ungleichung (4) erfüllen:

$$0 \leq n_M - n_R \leq 0,02 \qquad (4)$$

wobei $n_R$ den Brechungsindex der lichthärtbaren Zusammensetzung R bei der Wellenlänge von Licht a darstellt und $n_M$ den Brechungsindex der Form bei der Wellenlänge von Licht a darstellt.

5. Verfahren nach einem der Ansprüche 1 bis 4, wobei die lichthärtbare Zusammensetzung R hauptsächlich ein (Meth)acrylat enthält.

6. Verfahren nach einem der Ansprüche 1 bis 5, wobei das Gas 1,1,1,3,3-Pentafluorpropan enthält.

7. Verfahren nach Anspruch 6, wobei das Gas ein Gemisch aus 1,1,1,3,3-Pentafluorpropan und Helium ist.

8. Verfahren nach einem der Ansprüche 1 bis 5, wobei das Gas 1,1,1,3,3-Pentafluorpropan ist.

9. Verfahren nach einem der Ansprüche 1 bis 8, wobei die mit der lichthärtbaren Zusammensetzung R in Kontakt kommende Oberfläche der Form aus Quarz gefertigt ist.

10. Verfahren nach einem der Ansprüche 1 bis 8, wobei die gesamte Form aus Quarz gefertigt ist.

11. Verfahren nach einem der Ansprüche 1 bis 10, wobei die Ausrichtungsmarkierung A und die Ausrichtungsmarkierung B eine periodische konkavkonvexe Struktur aufweisen.

12. Verfahren nach einem der Ansprüche 1 bis 11, wobei Licht von der Ausrichtungsmarkierung A und der Ausrichtungsmarkierung B reflektiertes Licht oder gebeugtes Licht ist.

13. Verfahren nach Anspruch 1, ferner umfassend:

einen Schritt des Zuführens und Auftragens der lichthärtbaren Zusammensetzung auf das Substrat mit der Ausrichtungsmarkierung B von einem Mechanismus zum Auftragen der lichthärtbaren Zusammensetzung (5); einen Schritt des Bewegens einer Substratbühne (6), auf welcher das Substrat (9) vorgesehen ist, vom Mechanismus zum Auftragen der lichthärtbaren Zusammensetzung weg, sodass das Substrat so unter der Form (11) mit der Ausrichtungsmarkierung A platziert wird, dass die Ausrichtungsmarkierung A und die Ausrichtungsmarkierung B mit einer Genauigkeit von 1 Mikrometer bis 900 Mikrometer aufeinander ausgerichtet sind; und einen Schritt des Trennens der lichthärtbaren Zusammensetzung von der Form nach dem Bestrahlungsschritt, wobei das Gas ein hochlösliches Gas mit niedrigem Brechungsindex und einer Löslichkeit von 10 Volumenprozent oder mehr in der lichthärtbaren Zusammensetzung ist, und das Gas in flüssiger Form einen niedrigeren Brechungsindex als die lichthärtbare Zusammensetzung aufweist.

14. Verfahren zum Herstellen eines optischen Bauteils, wobei das Verfahren das Erzeugen eines strukturierten Films mithilfe des Verfahrens nach einem der Ansprüche 1 bis 12 umfasst.

15. Verfahren zum Herstellen eines optischen Bauteils, wobei das Verfahren umfasst:

Erzeugen eines strukturierten Films mithilfe des Verfahrens nach einem der Ansprüche 1 bis 12; und Bearbeiten des Substrats durch Ätzen oder Ionenimplantation unter Verwendung des strukturierten Films als Maske.

**16.** Verfahren zum Herstellen eines integrierten Schaltungselements, wobei das Verfahren umfasst:

Erzeugen eines strukturierten Films mithilfe des Verfahrens nach einem der Ansprüche 1 bis 12;
Bearbeiten des Substrats durch Ätzen oder Ionenimplantation unter Verwendung des strukturierten Films als Maske; und
Vorbereiten eines elektronischen Bauteils.

**17.** Verfahren zum Herstellen eines elektronischen Bauteils, wobei das Verfahren umfasst:

Herstellen eines integrierten Schaltungselements mithilfe des Verfahrens nach Anspruch 16; und
Verbinden des integrierten Schaltungselements mit einem Steuermechanismus, der konfiguriert ist, das integrierte Schaltungselement zu steuern.

**18.** Verfahren nach einem der Ansprüche 1 bis 17, wobei die Form eine Nanoprägeform mit einer Nanometerreliefstruktur an ihrer Oberfläche ist.

**19.** Verfahren nach Anspruch 16, wobei das integrierte Schaltungselement eine Halbleitervorrichtung ist.

**20.** Verwendung eines nach Anspruch 16 hergestellten integrierten Schaltungselements in einer Halbleitervorrichtung.

**21.** Verfahren zum Erzeugen einer Reliefstruktur durch Fotonanoprägung, wobei das Verfahren umfasst:

Bereitstellen einer lichthärtbaren Zusammensetzung, die ein Gas beinhaltet, zwischen einem Substrat mit einer Ausrichtungsmarkierung B und einer mit einem Relief auf ihrer Oberfläche versehenen Form mit einer Ausrichtungsmarkierung A;
Schätzen der Relativpositionsbeziehung zwischen der Ausrichtungsmarkierung A und der Ausrichtungsmarkierung B durch Bestrahlen der Ausrichtungsmarkierung A und der Ausrichtungsmarkierung B mit Licht, das nicht in der Lage ist, die lichthärtbare Zusammensetzung zu härten; und
Ausrichten der Ausrichtungsmarkierung A auf die Ausrichtungsmarkierung B durch Bewegen des Substrats relativ zur Form in einer zur Oberfläche des Substrats parallelen Richtung;
wobei das Gas, die lichthärtbare Zusammensetzung und die Form die folgende Ungleichung (1) erfüllen:

$$\left| n_M - n_R \right| \leq \left| n_M - n_{R'} \right| \qquad (1)$$

wobei $n_R$ den Brechungsindex der lichthärtbaren Zusammensetzung, die das Gas nicht beinhaltet, bei der Wellenlänge des Lichts darstellt, das nicht in der Lage ist, die lichthärtbare Zusammensetzung zu härten, $n_{R'}$ den Brechungsindex der lichthärtbaren Zusammensetzung, die das Gas beinhaltet, bei der Wellenlänge des Lichts darstellt, das nicht in der Lage ist, die lichthärtbare Zusammensetzung zu härten, und $n_M$ den Brechungsindex der Form bei der Wellenlänge des Lichts darstellt, das nicht in der Lage ist, die lichthärtbare Zusammensetzung zu härten.

## Revendications

**1.** Procédé pour former un film doté d'un motif, le procédé comprenant les étapes consistant à :

délivrer un gaz (16) entre une composition photodurcissable R (10) sur un substrat (9) ayant une marque d'alignement B (15) et un moule (11) ayant une marque d'alignement A (14) ;
mettre la composition photodurcissable R en contact avec le moule, la composition photodurcissable R devenant ainsi une composition photodurcissable R'dans laquelle le gaz est dissous ;
détecter une lumière à partir de la marque d'alignement A et de la marque d'alignement B en irradiant le moule et le substrat avec une lumière a ;
aligner la marque d'alignement A avec la marque d'alignement B conformément à la lumière détectée ;
durcir la composition photodurcissable R'en un film durci en irradiant la composition photodurcissable R'avec une lumière b ayant une longueur d'onde différente de celle de la lumière a ; et

séparer le film durci du moule,

dans lequel le gaz satisfait à l'inégalité (1) suivante :

$$|n_M - n_R| \leq |n_M - n_{R'}| \qquad (1)$$

dans laquelle $n_R$ représente l'indice de réfraction de la composition photodurcissable R à la longueur d'onde de la lumière a, $n_{R'}$ représente l'indice de réfraction de la composition photodurcissable R'à la longueur d'onde de la lumière a, et $n_M$ représente l'indice de réfraction du moule à la longueur d'onde de la lumière a.

2. Procédé selon la revendication 1, dans lequel le gaz satisfait à l'inégalité (2) suivante :

$$0 \leq n_M - n_R < n_M - n_{R'} \qquad (2)$$

dans laquelle $n_R$ représente l'indice de réfraction de la composition photodurcissable R à la longueur d'onde de la lumière a, $n_{R'}$ représente l'indice de réfraction de la composition photodurcissable R' à la longueur d'onde de la lumière a, et $n_M$ représente l'indice de réfraction du moule à la longueur d'onde de la lumière a.

3. Procédé selon la revendication 1 ou 2, dans lequel le gaz satisfait à l'inégalité (3) suivante :

$$0,01 \leq n_R - n_{R'} \qquad (3)$$

dans laquelle $n_R$ représente l'indice de réfraction de la composition photodurcissable R à la longueur d'onde de la lumière a, et $n_{R'}$ représente l'indice de réfraction de la composition photodurcissable R'à la longueur d'onde de la lumière a.

4. Procédé selon l'une quelconque des revendications 1 à 3, dans lequel la composition photodurcissable R et le moule satisfont à l'inégalité (4) suivante :

$$0 \leq n_M - n_R \leq 0,02 \qquad (4)$$

dans laquelle $n_R$ représente l'indice de réfraction de la composition photodurcissable R à la longueur d'onde de la lumière a, et $n_M$ représente l'indice de réfraction du moule à la longueur d'onde de la lumière a.

5. Procédé selon l'une quelconque des revendications 1 à 4, dans lequel la composition photodurcissable R contient principalement un (méth)acrylate.

6. Procédé selon l'une quelconque des revendications 1 à 5, dans lequel le gaz contient du 1,1,1,3,3-pentafluoropropane.

7. Procédé selon la revendication 6, dans lequel le gaz est un mélange de 1,1,1,3,3-pentafluoropropane et d'hélium.

8. Procédé selon l'une quelconque des revendications 1 à 5, dans lequel le gaz est le 1,1,1,3,3-pentafluoropropane.

9. Procédé selon l'une quelconque des revendications 1 à 8, dans lequel la surface du moule venant en contact avec la composition photodurcissable R est faite en quartz.

10. Procédé selon l'une quelconque des revendications 1 à 8, dans lequel la totalité du moule est faite en quartz.

11. Procédé selon l'une quelconque des revendications 1 à 10, dans lequel la marque d'alignement A et la marque d'alignement B ont une structure concavo-convexe périodique.

12. Procédé selon l'une quelconque des revendications 1 à 11, dans lequel la lumière à partir de la marque d'alignement A et de la marque d'alignement B est une lumière réfléchie ou une lumière diffractée.

**13.** Procédé selon la revendication 1, comprenant en outre :

une étape consistant à fournir et appliquer la composition photodurcissable sur le substrat ayant la marque d'alignement B à partir d'un mécanisme d'application de composition photodurcissable (5) ;
une étape consistant à déplacer un étage de substrat (6) sur lequel est disposé le substrat (9) par rapport au mécanisme d'application de composition photodurcissable de façon que le substrat soit placé sous le moule (11) ayant la marque d'alignement A, la marque d'alignement A étant alignée avec la marque d'alignement B selon une précision de 1 micromètre à 900 micromètres ; et
une étape consistant à séparer la composition photodurcissable du moule après l'étape d'irradiation,
dans lequel le gaz est un gaz très soluble ayant un faible indice de réfraction, dont la solubilité dans la composition photodurcissable est de 10 % en volume ou plus, et le gaz sous forme liquide a un indice de réfraction inférieur à celui de la composition photodurcissable.

**14.** Procédé pour fabriquer un composant optique, le procédé comprenant l'étape consistant à former un film doté d'un motif par le procédé tel que défini dans l'une quelconque des revendications 1 à 12.

**15.** Procédé pour fabriquer un composant optique, le procédé comprenant les étapes consistant à :

former un film doté d'un motif par le procédé tel que défini dans l'une quelconque des revendications 1 à 12 ; et
usiner le substrat par gravure ou implantation ionique utilisant, en tant que masque, le film doté d'un motif.

**16.** Procédé pour fabriquer un élément de circuit intégré, le procédé comprenant les étapes consistant à :

former un film doté d'un motif par le procédé tel que défini dans l'une quelconque des revendications 1 à 12 ;
usiner le substrat par gravure ou implantation ionique utilisant, en tant que masque, le film doté d'un motif ; et
préparer un composant électronique.

**17.** Procédé pour fabriquer un composant électronique, le procédé comprenant les étapes consistant à :

fabriquer un élément de circuit intégré par le procédé tel que défini dans la revendication 16 ; et
connecter l'élément de circuit intégré à un mécanisme de commande configuré pour commander l'élément de circuit intégré.

**18.** Procédé selon l'une quelconque des revendications 1 à 17, dans lequel le moule est un moule de nano-impression ayant un motif en relief nanométrique à sa surface.

**19.** Procédé selon la revendication 16, dans lequel l'élément de circuit intégré est un dispositif à semiconducteur.

**20.** Utilisation d'un élément de circuit intégré fabriqué selon la revendication 16 dans un dispositif à semiconducteur.

**21.** Procédé pour former un motif en relief par photonano-impression, le procédé comprenant les étapes consistant à :

disposer une composition photodurcissable contenant un gaz entre un substrat ayant une marque d'alignement B et un moule doté d'un relief à sa surface et ayant une marque d'alignement A ;
estimer la relation positionnelle relative entre la marque d'alignement A et la marque d'alignement B en irradiant la marque d'alignement A et la marque d'alignement B avec une lumière incapable de durcir la composition photodurcissable ; et
aligner la marque d'alignement A avec la marque d'alignement B en déplaçant le substrat par rapport au moule dans une direction parallèle à la surface du substrat,
dans lequel le gaz, la composition photodurcissable et le moule satisfont à l'inégalité (1) suivante :

$$|n_M - n_R| \leq |n_M - n_{R'}| \qquad (1)$$

dans laquelle $n_R$ représente l'indice de réfraction de la composition photodurcissable ne contenant pas le gaz à la longueur d'onde de la lumière incapable de durcir la composition photodurcissable, $n_{R'}$ représente l'indice de réfraction de la composition photodurcissable contenant le gaz à la longueur d'onde de la lumière incapable de durcir la composition photodurcissable, et $n_M$ représente l'indice de réfraction du moule à la longueur d'onde de la lumière incapable de durcir la composition photodurcissable.

[Fig. 1]

```
┌─────────────────────────────────────────────────────────┐
│   PHOTO-CURABLE COMPOSITION APPLYING STEP                │──STEP 1
│   APPLY PHOTO-CURABLE COMPOSITION R ONTO SUBSTRATE       │
└─────────────────────────────────────────────────────────┘
                          │
                          ▼
┌─────────────────────────────────────────────────────────┐
│   FIRST ALIGNMENT STEP                                   │──STEP 2
│   TRANSFER SUBSTRATE STAGE                               │
└─────────────────────────────────────────────────────────┘
                          │
                          ▼
┌─────────────────────────────────────────────────────────┐
│   GUS SUPPLY STEP                                        │──STEP 3
│   SUPPLY GAS                                             │
└─────────────────────────────────────────────────────────┘
                          │
                          ▼
┌─────────────────────────────────────────────────────────┐
│   CONTACTING STEP                                        │──STEP 4
│   BRING MOLD INTO CONTACT WITH PHOTO-CURABLE COMPOSITION R' │
└─────────────────────────────────────────────────────────┘
                          │
                          ▼
┌─────────────────────────────────────────────────────────┐
│   SECOND ALIGNMENT STEP                                  │──STEP 5
│   ALIGN MOLD ALIGNMENT MARK A WITH                       │
│   SUBSTRATE ALIGNMENT MARK B                             │
└─────────────────────────────────────────────────────────┘
                          │
                          ▼
┌─────────────────────────────────────────────────────────┐
│   IRRADIATION STEP                                       │──STEP 6
│   IRRADIATE PHOTO-CURABLE COMPOSITION R' WITH LIGHT TO BE CURED │
└─────────────────────────────────────────────────────────┘
                          │
                          ▼
┌─────────────────────────────────────────────────────────┐
│   DEMOLDING STEP                                         │──STEP 7
│   SEPARATE CURED COMPOSITION FROM MOLD                   │
└─────────────────────────────────────────────────────────┘
```

[Fig. 2]

[Fig. 3A]

[Fig. 3B]

[Fig. 3C]

[Fig. 3D]

[Fig. 3E]

[Fig. 3F]

[Fig. 4A]

[Fig. 4B]

112
102

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7136150 B
- JP 3700001 B
- WO 0210721 A
- EP 1731963 A
- JP 2013198446 A